# EUROPÄISCHE PATENTANMELDUNG

(11) **EP 1 832 983 A1**
(43) Veröffentlichungstag der Anmeldung: **12.09.2007**
(21) Anmeldenummer: 07100638.1
(22) Anmeldetag: 17.01.2007
(51) Int. Cl.: G06F 13/38, H03M 9/00

(54) **Schaltungsanordnung zur Gewinnung synchroner Zeitsignale**

(30) Priorität: 10.03.2006 DE 102006011286
(71) Anmelder: SIEMENS AKTIENGESELLSCHAFT ÖSTERREICH, 1220 Wien (AT)
(72) Erfinder: Hackl, Franz, 1130, Wien (AT); Hörist, Gerald, 1220, Wien (AT)

(57) **Zusammenfassung**

Schaltungsanordnung zur Gewinnung synchroner Zeitsignale mit einem Mikrocontroller (1), welcher einen Zeitgeber-Ausgang (GPO_{C}), einen Datenausgang (GPO_{D}) sowie einen Compare-Ausgang (C) zur Ausgabe eines Taktsignals umfasst, wobei innerhalb der Schaltungsanordnung ein Schieberegister (2) mit seriellem Eingang und parallelen Ausgängen sowie nachgeschaltetem Latch vorhanden ist und wobei ein Takteingang des Schieberegisters (SCK) mit dem Zeitgeber-Ausgang (GPO_{C}) und der serielle Eingang (D) des Schieberegisters mit dem Datenausgang (GPO_{D}) verbunden ist und wobei der Takteingang des Latch (RCK) mit dem Taktsignal beaufschlagt ist und wobei an den parallelen Ausgängen (A) des Latch die synchronen Zeitsignale abgreifbar sind. Ein preisgünstiger Mikrocontroller (1) mit nur einem quarzgenauen Taktsignal wird so zur Gewinnung mehrerer synchroner, quarzgenauer Zeitsignale genutzt.

## Beschreibung

Die Erfindung betrifft eine Schaltungsanordnung zur Gewinnung synchroner Zeitsignale mit einem Mikrocontroller, welcher einen Zeitgeber-Ausgang, einen Datenausgang sowie einen Compare-Ausgang zur Ausgabe eines Taktsignals umfasst. Des Weiteren betrifft die Erfindung ein Verfahren zum Betreiben der Schaltungsanordnung.

Verschiedenste Funktionen in elektrischen und elektronischen Schaltungen wie beispielsweise Messvorgänge oder präzise Schaltvorgänge benötigen die Vorgabe mehrerer synchroner Zeitsignale mit geringem Jitter und hoher Auflösung. Diese Zeitsignale müssen dabei in der Regel quarzgenau sein, um eine gewünschte Messgenauigkeit oder eine präzise Abfolge von Schaltvorgängen sicherzustellen.

Elektrische Geräte mit einer derartigen Schaltungsanordnung umfassen dabei in der Regel einen Mikrocontroller, der für die Steuerung der Schalt- und Messvorgänge eingerichtet ist. Ein solcher Mikrocontroller kann dann auch als Zeitsignalgeber eingerichtet sein.

Nach dem Stand der Technik werden dabei für die Gewinnung mehrerer synchroner Zeitsignale Mikrocontroller eingesetzt, welche eine umfangreiche interne Peripherie mit mehreren quarzgenauen Ausgängen umfassen.

Eine andere bekannte Variante sieht vor, in einer Schaltungsanordnung zusätzlich zu einem Mikrocontroller zumindest eine eigene Zeitgebereinheit vorzusehen, die über mehrere synchrone Ausgänge verfügt.

Der vorliegenden Erfindung liegt die Aufgabe zugrunde, für eine Schaltungsanordnung der eingangs genannten Art eine Verbesserung gegenüber dem Stand der Technik anzugeben.

Diese Aufgabe wird erfindungsgemäß gelöst mit einer Schaltungsanordnung zur Gewinnung synchroner Zeitsignale mit einem Mikrocontroller, welcher einen Zeitgeber-Ausgang, einen Datenausgang sowie einen Compare-Ausgang zur Ausgabe eines Taktsignals umfasst, wobei innerhalb der Schaltungsanordnung ein Schieberegister mit seriellem Eingang und parallelen Ausgängen sowie nachgeschaltetem Latch vorhanden ist und wobei ein Takteingang des Schieberegisters mit dem Zeitgeber-Ausgang und der serielle Eingang des Schieberegisters mit dem Datenausgang verbunden ist und wobei der Takteingang des Latch mit dem Taktsignal beaufschlagt ist und wobei an den parallelen Ausgängen des Latch die synchronen Zeitsignale abgreifbar sind.

Ein preisgünstiger Mikrocontroller mit nur einem quarzgenauen Taktsignal wird so zur Gewinnung mehrerer synchroner, quarzgenauer Zeitsignale genutzt. Es ist lediglich ein einfaches Schieberegister mit Latch (Ausgangsregister) erforderlich. Damit ergeben sich Einsparungen und Vereinfachungen bei der Herstellung elektrischer und elektronischer Geräte, deren Funktionen mehrere synchrone Zeitsignale erforderlich machen.

Die Zeitsignale können dabei durch eine entsprechende Einrichtung des Mikrocontrollers jederzeit geändert werden, wobei die höchste Auflösung durch den Takt des Taktsignals am Compare-Ausgang bestimmt ist.

In einer vorteilhaften Ausprägung der Erfindung ist das Schieberegister mit nachgeschaltetem Latch als integrierte Schaltung ausgebildet. Derartige Bauteile sind am Markt preisgünstig erhältlich und vereinfachen das Layout der Schaltungsanordnung.

Dabei ist es von Vorteil, wenn der Mikrocontroller einen weiteren Ausgang zur Übertragung eines Enable-Signals aufweist, der mit einem Enable-Eingang des Schieberegisters verbunden ist. Mit einem Enable-Signal werden dann die gewünschten Zeitsignale an den Ausgängen des Latch frei geschaltet, d.h. die synchronen Ausgänge werden nach dem Einschalten und beim Ausschalten in einen definierten Zustand gebracht.

Vorteilhaft ist es zudem, wenn der Mikrocontroller einen Ausgang zur Übertragung eines Löschsignals ausweist, der mit einem Lösch-Anschluss des Schieberegisters verbunden ist. Über diese Verbindung besteht die Möglichkeit, das Schieberegister jederzeit zurückzusetzen und neue Zeitsignalreihen zu starten.

Eine weitere vorteilhafte Ausprägung der Erfindung sieht vor, dass ein weiteres Schieberegister mit seriellem Eingang und parallelen Ausgängen sowie nachgeschaltetem Latch vorhanden ist und dass der serielle Eingang des weiteren Schieberegisters mit einem der parallelen Ausgänge des ersten Schieberegisters verbunden ist und dass die übrigen Eingänge des weiteren Schieberegisters parallel zu den entsprechenden Eingängen des ersten Schieberegisters geschaltet sind. Mit dieser Kaskadierung können weitere Ausgänge gewonnen werden, die sowohl untereinander als auch Schieberegisterübergreifend synchron sind.

In einer günstigen Ausprägung der Erfindung ist vorgesehen, dass der Mikrocontroller als PIC-Controller ausgebildet ist. Derartige Controller sind bewährte Bauelemente, die in einfacher Weise in die erfinderische Anordnung integrierbar sind. Sie verfügen über unterschiedliche interne Peripherieeinheiten wie z.B. einen Zeitgeber und einen Komparator.

Ein vorteilhaftes Verfahren zum Betreiben einer erfindungsgemäßen Schaltungsanordnung sieht vor, dass das Schieberegister bei Aktivierung mit den für die parallelen Ausgänge vorgegebenen Daten geladen wird, indem am seriellen Eingang ein erstes Bit angelegt und mit einer steigenden Flanke des am Takteingang des Schieberegisters anliegenden Signals in das Schieberegister geschoben wird und dass nachfolgende, am seriellen Eingang angelegte Bits in gleicher Weise in das Schieberegister geschoben werden und dass des Weiteren mit steigender Flanke des am Takteingang des Latchs anliegenden Taktsignals der Inhalt des Schieberegisters in das Latch übertragen wird.

Damit ist ein einfacher Vorgang bestimmt, wie die Ausgänge des Latchs mit den Startwerten der einzelnen Zeitsignalreihen belegt werden und wie sich die synchronen Zeitsignale im Takt des Taktsignals ändern.

Die Erfindung wird nachfolgend in beispielhafter Weise unter Bezugnahme auf die beigefügte Figur erläutert. Es zeigt in schematischer Darstellung:

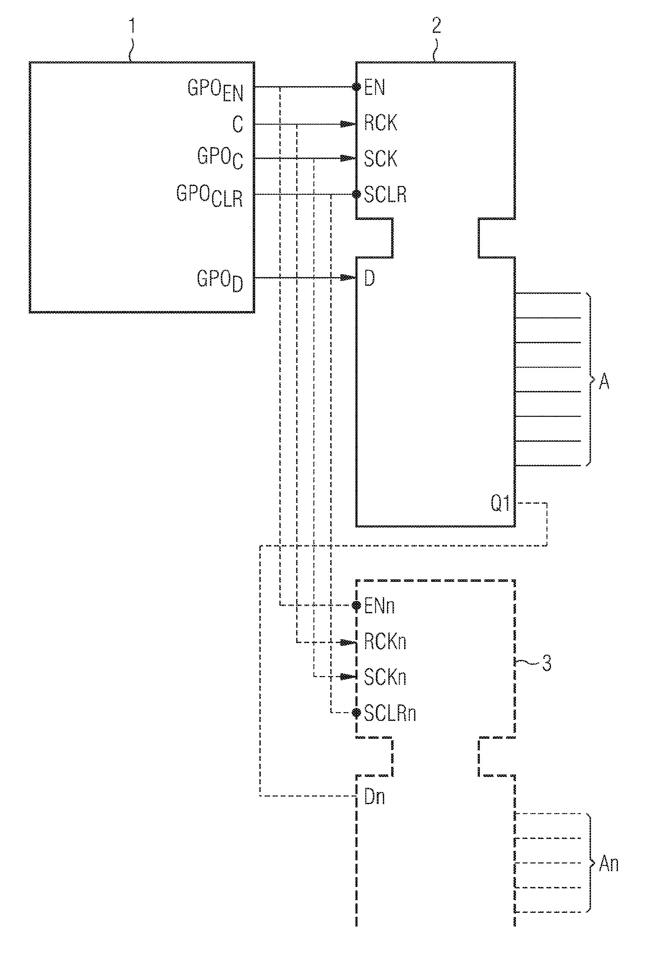

- Fig. 1:: Zuordnung der Anschlüsse des Mikrocontrollers und des Schieberegisters

In Figur 1 ist ein Mikrocontroller 1 dargestellt, wobei die für die vorliegende Schaltungsanordnung nutzbaren Ausgänge GPO_{EN}, C, GPO_{C}, GPO_{CLR}, GPO_{D} eingezeichnet sind. Dabei handelt es sich um vier programmierbare Ausgänge GPO_{EN}, GPO_{C}, GPO_{CLR}, GPO_{D}, so genannte General Purpose Outputs (GPO) und um einen Compare-Ausgang C, an dem ein quarzgenaues Taktsignal anliegt.

Als Mikrocontroller 1 kann beispielsweise ein PIC-Controller verwendet werden. Dabei handelt es sich um eine Mikrocontrollerfamilie, die von der Firma Microchip Technologie Inc. hergestellt wird, wobei unterschiedliche interne Peripherieeinheiten erhältlich sind. Für den vorliegenden Einsatz sind ein Zeitgeber und ein Komparator erforderlich.

Mit dem Mikrocontroller 1 ist ein seriell-ein/parallel-aus-Schieberegister 2 mit integriertem Latch verbunden (beispielsweise ein 74595-Schieberegister, 8-bit, Tristate, seriell-ein parallel-aus, Ausgangs-Latch, reset). Dabei ist ein Enable-Eingang EN mit einem ersten programmierbaren Ausgang zur Übertragung eines Enable-Signals GPO_{EN} verbunden. In Abhängigkeit des Enalbe-Signals liegen die parallelen Zeitsignale an den Ausgängen A z.B. dann an, wenn der Enable-Eingang EN auf Low liegt. Legt man diesen Anschluss auf High, gehen alle Ausgänge A in einen hochohmigen Zustand. Das Signal am Enable-Eingang EN bietet damit die Möglichkeit, die synchronen Ausgänge A nach dem Einschalten und beim Ausschalten in einen definierten Zustand zu bringen.

Der Compare-Ausgang C des Mikrocontrollers 1 ist mit dem Takteingang des Latch RCK und der als programmierbarer Ausgang ausgebildete Zeitgeber-Ausgang GPO_{C} ist mit dem Takteingang des Schieberegisters SCK verbunden. Des Weiteren ist der als programmierbarer Ausgang ausgebildete Datenausgang GPO_{D} mit dem seriellen Eingang D des Schieberegisters 2 verbunden.

Das Schieberegister 2 mit Latch arbeitet dann in der Weise, dass z.B. mit jeder positiven Flanke des am Takteingang des Schieberegisters SCK anliegenden Signals die Dateninformation am seriellen Eingang D übernommen und die im Schieberegister 2 bereits befindlichen Daten um eine Registerposition weiter geschoben werden. Wenn des Weiteren am Takteingang des Latch RCK ein Low-High-Übergang des Taktsignals erfolgt, werden die im Schieberegister befindlichen Daten in das Latch übernommen und sind bei entsprechendem Signal am Enable-Eingang EN an den Ausgängen A abgreifbar. Die Zeitsignale an den Ausgängen A sind dabei synchron mit dem Taktsignal. Bei einem transparenten Latch ist darauf zu achten, dass das Taktsignal am Takteingang des Latch RCK wieder auf Low übergeht, bevor über den seriellen Eingang D neue Bits in das Schieberegister 2 geschrieben werden.

In einer optionalen Erweiterung der erfindungsgemäßen Schaltungsanordnung besteht eine weitere Verbindung zwischen dem vierten programmierbaren Ausgang zur Übertragung eines Löschsignals GPO_{CLR} und dem Lösch-Anschluss SCLR des Schieberegisters 2. Dieser Anschluss liegt dann z.B. im Normalzustand auf High. Wird er auf Low gebracht, gehen alle Registerpositionen des Schieberegisters 2 auf Null. Damit besteht eine Möglichkeit, die Zeitsignale zurück zu setzten.

Die Inbetriebnahme der erfindungsgemäßen Schaltungsanordnung geschieht in der Weise, dass zunächst der Mikrocontroller aktiviert wird. Dieser ist dabei so eingerichtet, dass an den Anschlüssen die vorgegebenen Signale anliegen. Im nächsten Schritt wird das Schieberegister 2 mit Daten entsprechend den an den synchronen Ausgänge A gewünschten Zeitsignalen geladen. Dazu wird am seriellen Eingang D ein erstes Bit angelegt, das vom Mikrocontroller am Datenausgang GPO_{D} erzeugt wird. Mit der nächsten steigenden Flanke des Zeitgeber-Signals am Takteingang des Schieberegisters SCK wird dieses Bit in das Schieberegister 2 geschoben. Der Takt des Signals am Zeitgeber-Ausgang GPO_{C} braucht dabei nicht quarzgenau zu sein. Ein Jitter an diesem Signal hat keine Auswirkungen auf die Ausgänge A des Schieberegisters 2.

Mit den weiteren Bits wird ebenso verfahren, wobei sich das Datensignal am Datenausgang GPO_{D} entsprechend ändert, d.h. die Bits werden als diskretes Datensignal in der Reihenfolge am seriellen Eingang D des Schieberegisters 2 angelegt, wie sie für die Bildung der entsprechenden Zeitsignale an den synchronen Ausgängen A benötigt werden. Dabei wird mit jedem Low-High-Übergang am Takteingang des Schieberegisters SCK ein weiteres Bit im Schieberegister 2 angelegt und die bereits angelegten Bits um eine Registerposition weiter geschoben.

Währenddessen kann bereits die Komparatoreinheit des Mikrocontrollers aktiviert werden. Mit jedem Low-High-Übergang des am Compare-Ausgang C anliegenden Taktsignals wird der Inhalt des Schieberegisters 2 in das Latch übertragen. An den synchronen Ausgängen A liegen somit die entsprechenden Zeitsignale an. Dabei ist darauf zu achten, dass alle in einer Applikation verwendeten Registerpositionen des Schieberegisters 2 gefüllt sind, bevor mit einem Low-High-Übergang die Daten aus dem Schieberegister 2 in das Latch übertragen werden. Bei einer Applikation mit beispielsweise einem 8-bit Schieberegister 2 und vier erforderlichen synchronen Zeitsignalen müssen also zumindest die verwendeten vier Registerpositionen gefüllt sein, bevor am Takteingang des Latch RCK ein Low-High-Übergang anliegt.

Bei Schieberegistern unterscheidet man lineare (mit jedem Taktimpuls wird an einem Ende ein Bit eingefügt, während am anderen Ende eines "herausfällt") und zyklische (das "herausgefallene" Bit wird wieder am Anfang eingespeist) Verschiebungen. Bei der vorliegenden Erfindung wird in der Regel ein Schieberegister mit linearer Verschiebung gewählt, es werden also laufend neue Bits angelegt und so die einzelnen Zeitsignale weiterentwickelt.

Wenn eine Anwendung jedoch nur zyklische Zeitsignale erfordert, wobei ein Zyklus höchstens so viele diskrete Werte wie das Schieberegister Ausgänge aufweist, dann kann auch ein Schieberegister mit zyklischer Verschiebung zum Einsatz kommen. Das Datensignal am seriellen Eingang D wird in diesem Fall nur zum erstmaligen Anlegen der Bits im Schieberegister 1 benötigt.

In Figur 1 ist zudem eine mögliche Erweiterung der Schaltungsanordnung um ein weiteres Schieberegister 3 mit Latch mit gestrichelten Linien dargestellt. Dieses weitere Schieberegister 3 verfügt über die gleichen Eingänge wie das erste Schieberegister 2, wobei die beiden Takteingänge RCKn, SCKn, der Enable-Eingang ENn und der Lösch-Anschluss SCLRn des weiteren Schieberegisters 3 parallel zu den entsprechenden Anschlüssen RCK, SCK, EN, SCLR des ersten Schieberegisters 2 geschaltet sind. Der Datenanschluss Dn des weiteren Schieberegisters 3 ist jedoch mit Q1, einem Ausgang des Schieberegisters 2 verbunden. Dieser Ausgang Q1 des ersten Schieberegisters 2 ist parallel dazu weiterhin mit dem Latch des ersten Schieberegisters 2 verbunden.

Mit dieser Kaskadierung erhält man weitere Ausgänge An, die sowohl untereinander als auch Schieberegisterübergreifend synchron sind. Auf diese Weise können auch mehr als zwei Schieberegister zusammengeschaltet sein.

## Patentansprüche

1. Schaltungsanordnung zur Gewinnung synchroner Zeitsignale mit einem Mikrocontroller (1), welcher einen Zeitgeber-Ausgang (GPO_{C}), einen Datenausgang (GPO_{D}) sowie einen Compare-Ausgang (C) zur Ausgabe eines Taktsignals umfasst, **dadurch gekennzeichnet, dass** innerhalb der Schaltungsanordnung ein Schieberegister (2) mit seriellem Eingang (D) und parallelen Ausgängen sowie nachgeschaltetem Latch vorhanden ist und dass ein Takteingang des Schieberegisters (SCK) mit dem Zeitgeber-Ausgang (GPO_{C}) und der serielle Eingang (D) des Schieberegisters mit dem Datenausgang (GPO_{D}) verbunden ist und dass der Takteingang des Latch (RCK) mit dem Taktsignal beaufschlagt ist und dass an den parallelen Ausgängen (A) des Latch die synchronen Zeitsignale abgreifbar sind.

2. Schaltungsanordnung nach Anspruch 1, **dadurch gekennzeichnet, dass** das Schieberegister (2) mit nachgeschaltetem Latch als integrierte Schaltung ausgebildet ist.

3. Schaltungsanordnung nach Anspruch 1 oder 2, **dadurch gekennzeichnet, dass** der Mikrocontroller (1) einen weiteren Ausgang zur Übertragung eines Enable-Signals (GPO_{EN}) aufweist, der mit einem Enable-Eingang (EN) des Schieberegisters (2) verbunden ist.

4. Schaltungsanordnung nach einem der Ansprüche 1 bis 3, **dadurch gekennzeichnet, dass** der Mirocontroller (1) einen weiteren Ausgang zur Übertragung eines Löschsignals (GPO_{CLR}) aufweist, der mit einem Lösch-Anschluss (SCLR) des Schieberegisters (2) verbunden ist.

5. Schaltungsanordnung nach einem der Ansprüche 1 bis 4, **dadurch gekennzeichnet, dass** ein weiteres Schieberegister (3) mit seriellem Eingang (Dn) und parallelen Ausgängen sowie nachgeschaltetem Latch vorhanden ist und dass der serielle Eingang (Dn) des weiteren Schieberegisters (3) mit einem Ausgang (Q1) des ersten Schieberegisters (1) verbunden ist und dass die übrigen Eingänge (ENn, RCKn, SCKn, SCLRn) des weiteren Schieberegisters (3) parallel zu den entsprechenden Eingängen (EN, RCK, SCK, SCLR) des ersten Schieberegisters (2) geschaltet sind.

6. Schaltungsanordnung nach einem der Ansprüche 1 bis 5, **dadurch gekennzeichnet, dass** der Mirocontroller (1) als PIC-Controller ausgebildet ist.

7. Verfahren zum Betrieb einer Schaltungsanordnung nach einem der Ansprüche 1 bis 6, **dadurch gekennzeichnet, dass** das Schieberegister (2) bei Aktivierung mit den für die parallelen Ausgänge (A) vorgegebenen Daten geladen wird, indem am seriellen Eingang (D) ein erstes Bit angelegt und mit einer steigenden Flanke des am Takteingang des Schieberegisters (SCK) anliegenden Signals in das Schieberegister (2) geschoben wird und dass nachfolgende, am seriellen Eingang (D) angelegte Bits in gleicher Weise in das Schieberegister (2) geschoben werden und dass des Weiteren mit steigender Flanke des am Takteingang des Latchs (RCK) anliegenden Taktsignals der Inhalt des Schieberegisters (2) in das Latch übertragen wird.
